# EUROPÄISCHE PATENTSCHRIFT

(11) **EP 0 982 806 B1**
(45) Veröffentlichungstag und Bekanntmachung des Hinweises auf die Patenterteilung: **05.03.2003**
(21) Anmeldenummer: 99115507.8
(22) Anmeldetag: 05.08.1999
(51) Int. Cl.: H01R 12/18, H05K 13/04

(54) **Trägerbauteil mit elektrischen Kontaktelementen zum Einbau in einer Leiterplatte**
Connector with electric contact elements adapted to be mounted on a circuit board
Connecteur avec éléments de contact adapté à être monté sur une plaquette à circuits imprimés

(30) Priorität: 12.08.1998 DE 19836548
(43) Veröffentlichungstag der Anmeldung: 01.03.2000
(73) Patentinhaber: Delphi Technologies, Inc., Troy, MI 48007 (US)
(72) Erfinder: Ebbinghaus, Peter Paul, 58256 Ennepetal (DE)
(74) Vertreter: Manitz, Finsterwald & Partner GbR

(56) Entgegenhaltungen:
- EP-A- 0 707 359
- EP-A- 0 872 919
- GB-A- 2 316 550
- US-A- 5 342 208

## Beschreibung

Die Erfindung betrifft ein Trägerbauteil mit elektrischen Kontaktelementen zum Einbau in einer Leiterplatte, die eine mit oberflächenmontierten Bauteilen (SMD) bestückbare Oberseite und eine unbestückte Unterseite aufweist.

Bei derartigen Leiterplatten, wie sie aus dem Stand der Technik bekannt sind, besteht häufig das Bedürfnis, an der unbestückten Unterseite einen Steckkontakt, z.B. für einen Kabelsatz oder andere Bauteile anzubringen. Produktionstechnisch werden derartige Anforderungen bisher dadurch gelöst, daß zunächst die Leiterplattenoberseite bestückt und verlötet wird und in einem nächsten Arbeitsschritt die Unterseite mit einem Stecker bestückt wird und der Stecker, dessen Kontaktstifte durch Bohrungen der Leiterplatte hindurchgeführt und an der Oberseite in einem dritten Arbeitsschritt verlötet werden. Aufgrund des hierfür erforderlichen Vorrichtungs- und Arbeitsaufwands ist die Fertigung derartiger Bauteile kostspielig und anfällig für Fehler.

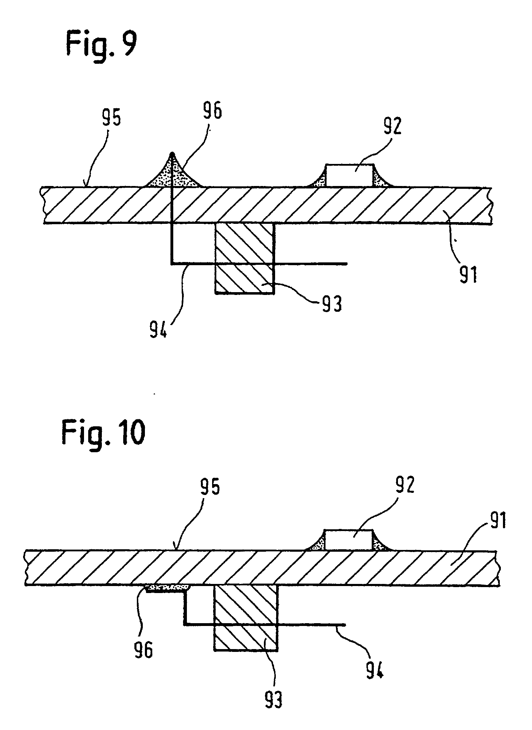

Ein Beispiel für eine derart hergestellte einseitig bestückte Leiterplatte mit auf der unbestückten Unterseite angebrachtem Kontaktelement ist in Fig. 9 dargestellt. Darin ist eine einseitig bestückte Leiterplatte 91 ein oberflächenmontierbares Bauteil (SMD) 92 und ein Stecker 93 mit Kontaktstift 94 sowie eine an der Oberseite 95 angebrachte Lötstelle 96 dargestellt. Nach Bestücken des SMD 92 und Verlöten desselben mit der Leiterplatte 91 wird auf der unbestückten Unterseite der Leiterplatte 91 ein Stecker 93 angebracht. Dabei ist der Stecker so positioniert, daß ein Ende des Kontaktstifts 94 durch eine Bohrung in der Leiterplatte eingeführt wird, damit es auf der Oberseite der Leiterplatte verlötet werden kann.

Alternativ werden zweiseitig bestückbare Leiterplatten verwendet. Ein Beispiel hierfür ist in Fig. 10 dargestellt, worin gleiche Teile gleiche Bezugszeichen wie in Fig. 9 aufweisen. Im Gegensatz zu der in Fig. 9 gezeigten Darstellung muß der Kontaktstift hier nicht durch eine Bohrung der Leiterplatte 91 zu deren Oberseite 95 geführt werden, da sich die Lötstelle 96 an der Unterseite der Leiterplatte befindet.

Den Leiterplatten nach dem Stand der Technik ist gemeinsam, daß sie von beiden Seiten bestückt werden müssen und in zwei Arbeitsgängen verlötet werden.

Es ist daher Aufgabe der vorliegenden Erfindung, die o.g. Nachteile zu vermeiden und das kostengünstige Anbringen von Elementen an der Unterseite einer einseitig bestückten Leiterplatte zu ermöglichen.

Diese Aufgabe wird durch ein Trägerbauteil mit den Merkmalen des Anspruch 1 gelöst. Vorteilhafte Ausführungsformen der Erfindung sind in den Unteransprüchen dargestellt.

Gemäß der vorliegenden Erfindung ist es vorgesehen, ein Trägerbauteil mit elektrischen Kontaktelementen zum Einbau in einer Leiterplatte zur Verfügung zu stellen, wobei die Leiterplatte eine mit oberflächenmontierten Bauteilen (SMD) bestückbare Oberseite und eine unbestückte Unterseite aufweist. Das Trägerbauteil ist bevorzugt von der Oberseite der Leiterplatte in einer dafür vorgesehenen Aussparung derselben montierbar, um eine Kontaktierung an der Unterseite der Leiterplatte zu ermöglichen. Dadurch entfällt ein zusätzlicher Montage- und Lötprozeß, der bei Leiterplatten nach dem Stand der Technik erforderlich ist. Derartige einseitig bestückte Leiterplatten mit auf der unbestückten Unterseite angebrachten Kontaktstiften sind z.B. zur Verbindung der Leiterplatte mit Kabeln, Stekkem oder anderen Kontaktstücken erforderlich.

Weiterhin ist vorgesehen, daß das Trägerbauteil von den Kontaktelementen durchdrungen ist. Hierdurch werden die beispielsweise als Kontaktstifte ausgeführten Kontaktelemente einfach fixiert, d.h. das Trägerbäuteil ist einfach und kostengünstig herstellbar. Je nach Materialwahl des Trägerbauteils können die Kontaktelemente beispielsweise darin eingegössen sein.

Die Kontaktelemente sind derart angeordnet, daß deren mit der Leiterplatte durch Löten zu verbindende Enden an der Oberseite und deren zu kontaktierende freien Enden an der Unterseite der Leiterplatte angeordnet sind. Hierdurch wird erreicht, daß außer dem Bestückungsvorgang nur ein Lötvorgang für die auf der Oberfläche montierten SMDs erforderlich ist.

Eine weitere vorteilhafte Ausführungsform sieht vor, daß das Trägerbauteil als Platte ausgebildet ist, die eine zumindest teilweise abgesetzte Umrandung aufweist. Durch die Ausgestaltung als Platte und entsprechende Absätze an deren Umrandung wird eine besonders flache Bauweise ermöglicht, die bei Einbau einer Leiterplatte in Bauteile mit begrenztem Bauraum erhebliche Vorteile mit sich bringt.

Es ist nach einer weiteren erfindungsgemäßen Ausführungsform vorteilhaft, daß das Trägerbauteil eine rechteckige Grundfläche aufweist, wodurch Trägerbauteile mit nebeneinander angeordneten einreihigen oder mehrreihigen Kontaktstiften einfach und platzsparend realisierbar sind.

Es sind aber auch andere Gestaltungen denkbar, beispielsweise eine kreisförmige Platte für einen einzelnen Kontaktstift.

Eine Ausführungsform der Erfindung sieht vor, daß als Kontaktelemente einreihige um 90° abgewinkelte Kontaktstifte vorgesehen sind. Hierdurch lassen sich flache einreihige Steckkontaktbuchsen an den freien Enden der Kontaktstifte anschließen, deren Kabelstrang parallel zur Leiterplatte verläuft und daher nur einen geringen Platzbedarf aufweist.

Eine weitere Ausführungsform sieht vor, daß als Kontaktelemente einreihige gerade Kontaktstifte vorgesehen sind. Dies ermöglicht es, eine einfache Kabelführung senkrecht zur Leiterplatte zu realisieren.

Desweiteren sieht noch eine vorteilhafte Ausführungsform der vorliegenden Erfindung vor, daß als Kontaktelemente doppelreihig um 90° gewinkelte Kontaktstifte vorgesehen sind. Dies ermöglicht eine Kopplung mit einer doppelreihigen Steckerbuchse, bei der die Kabel parallel zur Leiterplatte geführt werden können.

Schließlich sieht noch eine vorteilhafte Ausführungsform vor, daß als Kontaktelemente doppelreihig gerade Kontaktstifte vorgesehen sind. Dadurch kann eine senkrecht zur Leiterplatte wegführende Kabelanordnung realisiert werden.

Im folgenden werden vorteilhafte Ausgestaltungen der vorliegenden Erfindung anhand der beigefügten Zeichnungen beschrieben. Darin zeigen:
- Fig. 1:: Eine Seitenansicht im Schnitt einer erfindungsgemäßen Ausführungsform mit einreihigen Kontaktelementen, die um 90° abgewinkelt sind;
- Fig. 2:: Eine Draufsicht auf das Trägerbauteil aus Fig. 1;
- Fig. 3:: Eine Seitenansicht im Schnitt einer Ausführungsform der vorliegenden Erfindung mit einreihigen Kontaktelementen in gerader Ausführung;
- Fig. 4:: Eine Draufsicht auf das Trägerbauteil aus Fig. 3;
- Fig. 5:: Eine Seitenansicht im Schnitt einer Ausführungsform der vorliegenden Erfindung mit doppelreihigen Kontaktelementen in gerader Ausführung;
- Fig. 6:: Eine Draufsicht auf das Trägerbauteil aus Fig. 5;
- Fig. 7:: Eine Seitenansicht im Schnitt einer weiteren Ausführungsform der vorliegenden Erfindung mit doppelreihigen Kontaktelementen, die um 90° abgewinkelt sind;
- Fig. 8:: Eine Draufsicht auf das Trägerbauteil aus Fig. 7;
- Fig. 9:: Eine einseitig bestückte Leiterplatte nach dem Stand der Technik;
- Fig. 10:: Eine doppelseitig bestückte Leiterplatte nach dem Stand der Technik.

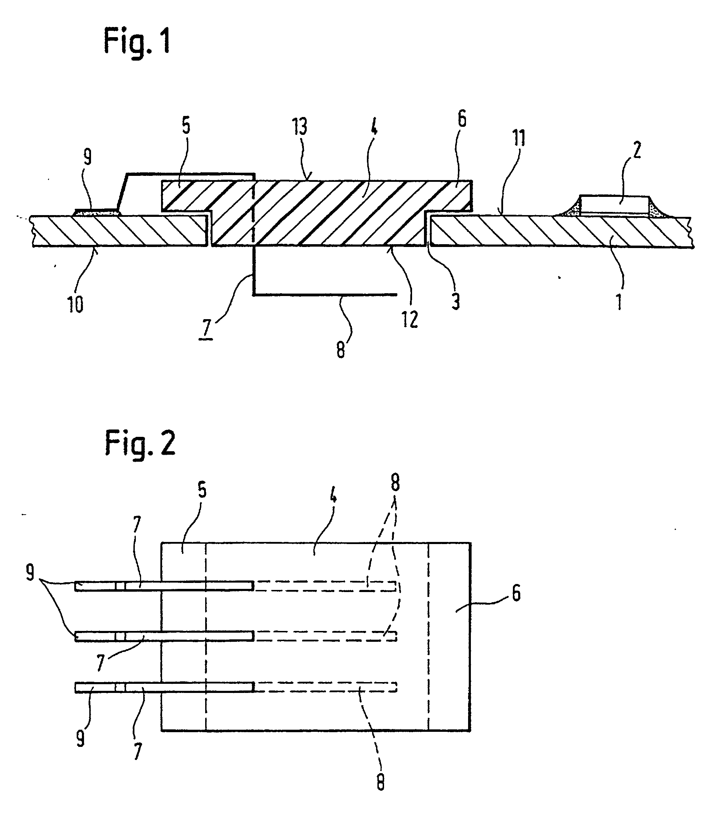

Fig. 1 zeigt schematisch eine geschnittene Seitenansicht einer Ausführungsform der vorliegenden Erfindung. Darin ist eine einseitig.mit oberflächenmontierbaren Bauteilen (SMD) 2 bestückte Leiterplatte 1 dargestellt. Die Leiterplatte 1 weist eine Aussparung 3 auf, in der ein Trägerbauteil 4 aufgenommen ist. Das Trägerbauteil 4 ist im vorliegenden Ausführungsbeispiel aus nicht-leitendem Kunststoff hergestellt und als rechteckige Platte ausgeführt. Ferner weist das Trägerbauteil an seinen beiden Stirnseiten bzw. an seinen Unterseite 12 Absätze 5, 6 auf, wie auch aus der Draufsicht auf das Trägerbauteil in Fig. 2 zu erkennen ist. Das Trägerbauteil 4 liegt mit seinen Absätzen 5, 6 auf der Bestückungsseite der Leiterplatte 1 auf und ist mit dieser verbunden. Das Trägerbauteil 1 weist ferner Kontaktelemente 7 auf, die, wie in Fig. 1 gezeigt, das Trägerbauteil 4 durchdringen und einreihig um 90° abgewinkelt montiert sind, wie in Fig. 2 gezeigt. Die Kontaktelemente 7 weisen zu kontaktierende freie Enden 8 auf. Diese ragen an der Unterseite 12 des Trägerbauteils 4 hervor. Auf der Oberseite 13 des Trägerbauteils sind zu verbindende Enden 9 der Kontaktelemente 7 durch Löten mit der Leiterplatte 1 verbunden.

Die Bestückung der Leiterplatte 1 mit den oberflächenmontierbaren Bauteilen 2 und 4 erfolgt in einem Arbeitsgang, obwohl die Kontaktierung mittels der Kontaktelemente 7 an der Unterseite 10 der Leiterplatte erfolgen soll. Hierzu werden vorgefertigte Leiterplatten 1 verwendet, die Aussparungen 3 aufweisen. In die Aussparung 3 der Leiterplatte wird das Trägerbauteil 4 von der Oberseite 11 eingesetzt. Das Trägerbauteil 4 sitzt dabei auf den Absätzen 5, 6 auf der Oberseite 11 der Leiterplatte 1 auf und kann dabei beispielsweise auch verklebt werden. Aber auch andere geeignete Verbindungen sind möglich. Nach dem Bestückungsvorgang erfolgt die elektrische Verbindung der oberflächenmontierbaren Bauteile 2, 4 durch Löten. Dabei wird das Trägerbauteil 4 über die Verbindungsenden 9 der Kontaktelemente 7 elektrisch mit der Leiterplatte 1 verbunden. Die freien Enden 8, die an der Unterseite 10 der Leiterplatte 4 hervorstehen, dienen zur Kontaktierung der Leiterplatte mit einer Steckverbindung. Hierzu können Stecker verwendet werden, die herkömmlicherweise für Kabelsätze oder sonstige Bauteile Verwendung finden. Der beschriebene Bestückungs- und Lötvorgang wird auch als "SMD-Reflow-Soldering" bezeichnet. Durch die Verwendung des Trägerbauteils 4 entfällt der sonst erforderliche zusätzliche Bestückungsvorgang für Kontaktelemente von der Unterseite 10 und der damit verbundene zusätzliche Lötprozeß.

Im folgenden werden für gleiche Bauteile gleiche Bezugszeichen verwendet.

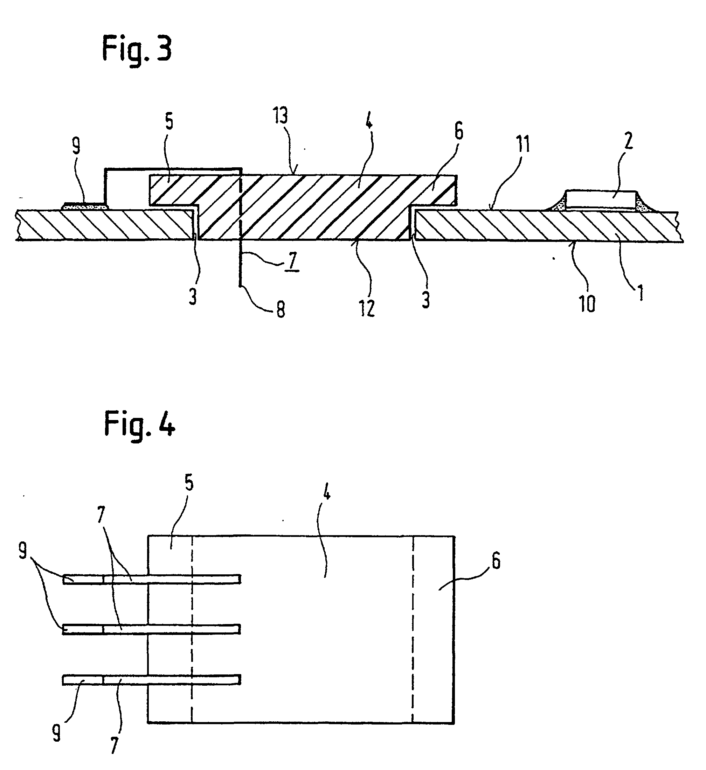

Fig. 3 und 4 zeigen eine zweite Ausführungsform der vorliegenden Erfindung, die sich von der Ausführungsform gemäß Fig. 1 und 2 darin unterscheidet, daß die freien Enden 8 der Kontaktelemente 7 senkrecht zu dem Trägerbauteil 4 verlaufen. Dies ermöglicht eine einfache Kabelverbindung mit der Leiterplatte, wobei die Kabelführung senkrecht zur Leiterplatte erfolgt. Der Fertigungsvorgang unterscheidet sich nicht von dem zu Fig. 1 und 2 beschriebenen.

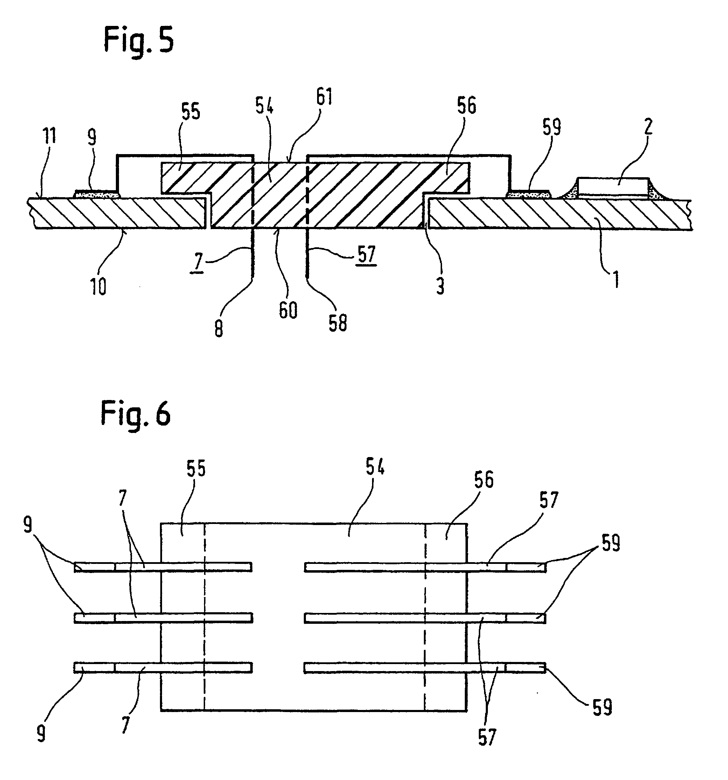

Fig. 5 und 6 zeigen schematisch eine dritte Ausführungsform der vorliegenden Erfindung. Dabei zeigt Fig. 5 eine Seitenansicht dieser Ausführungsform im Schnitt und Fig. 6 eine Draufsicht auf das Trägerbauteil aus Fig. 5. Gegenüber der zu Fig. 1 und 2 beschriebenen Ausführungsform weist die hier gezeigte Ausführungsform eine zweite Reihe von Kontaktelementen 57 auf, die wie die Kontaktelemente 7 als Kontaktstifte ausgebildet sind. Die freien Enden 8, 58 sind gerade ausgeführt und stehen senkrecht aus dem Trägerbauteil 54 auf dessen Unterseite 60 hervor. Die Verbindungsenden 9, 59 stehen jeweils über die Absätze 55, 56 des Trägerbauteils 54 hervor und sind mit der Leiterplatte 1 an deren Oberseite 11 durch Löten verbunden, wobei diese hierfür zweimal stufenartig um etwa 90° abgewinkelt sind. Gegenüber dem zu Fig. 1 und 2 beschriebenen Montagevorgang werden bei der Montage der Trägerplatte 54 lediglich drei zusätzliche Lötpunkte an den freien Enden 59 der Kontaktelemente 57 nötig, die jedoch im gleichen Arbeitsgang erfolgen.

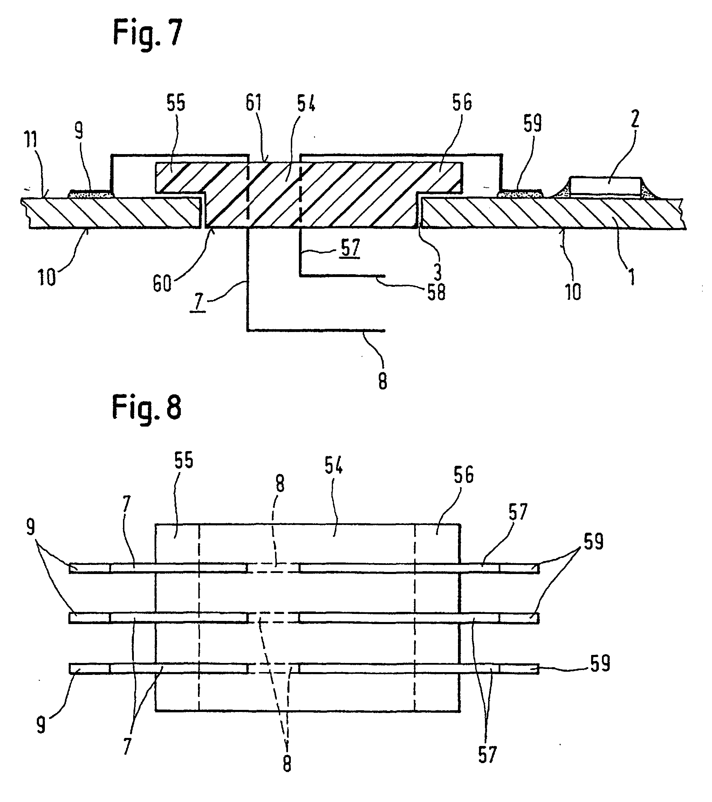

Fig. 7 und 8 zeigen eine weitere Ausführungsform ähnlich der in Fig. 5 und 6 beschriebenen Ausführungsform, jedoch mit um 90° abgewinkelten freien Enden 8, 58, die in zwei Ebenen unterhalb der Leiterplatte 1 angeordnet sind.

Es sei festgestellt, daß die Anzahl der Reihen von Kontaktelementen bei den dargestellten Ausführungsbeispielen nur beispielhaft ist und grundsätzlich beliebig viele Kontaktreihen vorgesehen werden können.

### Bezugszeichenliste

- 1: Leiterplatte
- 2: SMD
- 3: Aussparung
- 4: Trägerbauteil
- 5, 6: Absatz
- 7: Kontaktelement
- 8: freie Enden
- 9: Verbindungsenden
- 10: Unterseite der Leiterplatte
- 11: Oberseite der Leiterplatte
- 12: Unterseite des Trägerbauteils
- 13: Oberseite des Trägerbauteils
- 54: Trägerbauteil
- 55, 56: Absätze
- 57: Kontaktelemente
- 58: freie Enden
- 59: Verbindungsenden
- 60: Unterseite des Trägerbauteils
- 61: Oberseite des Trägerbauteils
- 91: Leiterplatte
- 92: SMD
- 93: Stecker
- 94: Kontaktstift
- 95: Oberseite
- 96: Lötstelle

## Patentansprüche

1. Trägerbauteil (4; 54) mit elektrischen Kontaktelementen (7; 57) zum Einbau in eine Aussparung (3) einer Leiterplatte (1), die eine mit oberflächenmontierten Bauteilen (2) bestückbare Oberseite (11; 61) und eine unbestückte Unterseite (10; 60) aufweist, um eine Kontaktierung an der Unterseite (10; 60) der Leiterplatte (1) zu ermöglichen,
wobei das Trägerbauteil (4; 54) von den elektrischen Kontaktelementen (7; 57) durchdrungen ist, und
wobei die elektrischen Kontaktelemente (7; 57) mit der Oberseite (11; 61) der Leiterplatte (1) durch Löten zu verbindende Enden (9; 59), die an der Oberseite (11;61) der Leiterplatte angeordnet sind, wenn das Trägerbauteil in die Aussparung (3) der Leiterplatte (1) eingebaut ist, und zu kontaktierende freie Enden (8; 58) aufweisen, die an der Unterseite (10; 60) der Leiterplatte angeordnet sind, wenn das Trägerbauteil in die Aussparung (3) der Leiterplatte (1) eingebaut ist.

2. Trägerbauteil nach Anspruch 1, **dadurch gekennzeichnet, daß** das Trägerbauteil (4; 54) als Platte ausgebildet ist, die eine zumindest teilweise abgesetzte Umrandung aufweist.

3. Trägerbauteil nach Anspruch 1, **dadurch gekennzeichnet, daß** das Trägerbauteil (4; 54) eine rechteckige Grundfläche aufweist.

4. Trägerbauteil nach Anspruch 1, **dadurch gekennzeichnet, daß** als Kontaktelemente (7; 57) einreihige um 90° abgewinkelte Kontaktstifte vorgesehen sind.

5. Trägerbauteil nach Anspruch 1, **dadurch gekennzeichnet, daß** als Kontaktelemente (7; 57) einreihige gerade Kontaktstifte vorgesehen sind.

6. Trägerbauteil nach Anspruch 1, **dadurch gekennzeichnet, daß** als Kontaktelemente (7; 57) doppelreihige um 90° abgewinkelte Kontaktstifte vorgesehen sind.

7. Trägerbauteil nach Anspruch 1, **dadurch gekennzeichnet, daß** als Kontaktelemente (7; 57) doppelreihige gerade Kontaktstifte vorgesehen sind.

## Claims

1. Carrier component (4; 54) with electrical contact elements (7; 57) for installation in a circuit board (1) having an upper side (11; 61) which can be equipped with surface mounted devices (2) and an unequipped lower side (10; 60), in order to enable a contacting at the lower side (10; 60) of the circuit board (1), wherein the electrical contact elements (7; 57) pass through the carrier component (4; 54) and the contact elements (7; 57) have ends (9; 59) arranged at the upper side (11, 61) of the circuit board which are to be connected through soldering to the upper side of the circuit board (1) when the carrier component is installed in the cut-out (3) of the circuit board (1) and free ends (8; 58) to be contacted which are arranged at the lower side (10; 60) of the circuit board (1) when the carrier component is installed in the cut-out (3) of the circuit board (1).

2. Carrier component in accordance with claim 1 **characterised in that** the carrier component (4; 54) is executed as a plate which has an at least partially offset border.

3. Carrier component in accordance with claim 1 **characterised in that** the carrier component (4; 54) has a rectangular base surface.

4. Carrier component in accordance with claim 1 **characterised in that** single row contact pins which are angled by 90° are provided as contact elements (7; 57).

5. Carrier component in accordance with claim 1 **characterised in that** single row straight contact pins are provided as contact elements (7; 57).

6. Carrier component in accordance with claim 1 **characterised in that** double row contact pins which are angled by 90° are provided as contact elements (7; 57).

7. Carrier component in accordance with claim 1 **characterised in that** double row straight contact pins are provided as contact elements (7; 57).

## Revendications

1. Composant support (4 ; 54) ayant des éléments de contact électriques (7 ; 57) pour le montage dans un évidement (3) d'une carte imprimée (1) qui présente une face supérieure (11 ; 61) pouvant être équipée de composants montés en surface (2) et une face inférieure (10 ; 60) non équipée afin de permettre une connexion à la face inférieure (10 ; 60) de la carte imprimée (1), le composant support(4 ; 54) étant traversé par les éléments de contact électriques (7 ; 57), et les éléments de contact électriques (7 ; 57) présentant des extrémités (9 ; 59) à relier par brasage à la face supérieure (11 ; 61) de la carte imprimée (1) qui sont disposées à la face supérieure (11 ; 61) de la carte imprimée lorsque le composant support est monté dans l'évidement (3) de la carte imprimée (1), et présentant des extrémités libres (8 ; 58) à connecter qui sont disposées à la face inférieure (10 ; 60) de la carte lorsque quand le composant support est monté dans l'évidement (3) de la carte imprimée (1).

2. Composant support selon la revendication 1, **caractérisé en ce que** le composant support (4 ; 54) est configuré comme une carte qui présente une bordure au moins partiellement décalée.

3. Composant support selon la revendication 1, **caractérisé en ce que** le composant support (4 ; 54) présente une superficie rectangulaire.

4. Composant support selon la revendication 1, **caractérisé en ce que** des broches de contact coudées de 90° à une rangée sont prévues comme éléments de contact (7 ; 57).

5. Composant support selon la revendication 1, **caractérisé en ce que** des broches de contact droites à une rangée sont prévues comme éléments de contact (7 ; 57).

6. Composant support selon la revendication 1, **caractérisé en ce que** des broches de contact coudées de 90° à deux rangées sont prévues comme éléments de contact (7 ; 57).

7. Composant support selon la revendication 1, **caractérisé en ce que** des broches de contact droites à deux rangées sont prévues comme éléments de contact (7 ; 57).
